(19) **Europäisches Patentamt**

**European Patent Office**

**Office européen des brevets**

(11) **EP 1 089 446 A1**

(12) **EUROPEAN PATENT APPLICATION**
published in accordance with Art. 158(3) EPC

(43) Date of publication:
04.04.2001 Bulletin 2001/14

(51) Int. Cl.[7]: **H04B 1/30**, H04L 27/22,
H04J 13/00

(21) Application number: **99907914.8**

(22) Date of filing: **11.03.1999**

(86) International application number:
**PCT/JP99/01204**

(87) International publication number:
**WO 00/54421 (14.09.2000 Gazette 2000/37)**

(84) Designated Contracting States:
**DE FR GB**

(71) Applicant:
**MITSUBISHI DENKI KABUSHIKI KAISHA
Tokyo 100-8310 (JP)**

(72) Inventors:
• **KATSURA, Takatoshi,
Mitsubishi Denki K. Kaisha
Tokyo 100-8310 (JP)**
• **ITOH, Kenji,
Mitsubishi Denki K. Kaisha
Tokyo 100-8310 (JP)**
• **FUKUYAMA, Shinjirou,
Mitsubishi Denki K. Kaisha
Tokyo 100-8310 (JP)**

• **MOCHIZUKI, Mitsuru,
Mitsubishi Denki K. Kaisha
Tokyo 100-8310 (JP)**
• **NAGANO, Hiroaki,
Mitsubishi Denki K. Kaisha
Tokyo 100-8310 (JP)**
• **MATSUNAMI, Yoshinori,
Mitsubishi Denki K. Kaisha
Tokyo 100-8310 (JP)**

(74) Representative:
**Sajda, Wolf E., Dipl.-Phys. et al
MEISSNER, BOLTE & PARTNER
Postfach 86 06 24
81633 München (DE)**

(54) **RADIO TERMINAL DEVICE**

(57) A wireless terminal device includes an antenna (10), a transmitting circuit (11), a direct conversion receiving circuit (12), a circulator (13) and a band rejection filter (14). The direct conversion receiving circuit (12) can have smaller sizes than a receiving circuit of a heterodyne type, and is required to remove fewer spurious jamming waves. Owing to them, the whole size of the wireless terminal device can be small. Further, the direct conversion receiving circuit (12) includes even harmonic mixers (20 and 21), and a frequency (flo) of a local oscillation wave (LO) is equal to half a frequency (frx) of the received wave so that leakage of the local oscillation wave (LO) toward the antenna (10) and therefore deterioration in sensitivity do not occur.

FIG.1

## Description

<u>Technical Field</u>

The present invention relates a wireless terminal device of a CDMA (Code Division Multiple Access) type or the like, which simultaneously performs transmission (sending) and reception.

<u>Background Art</u>

In wireless terminal devices (e.g., a cellular telephone) of a type such as a CDMA type simultaneously performing transmission and reception, a single antenna is often used for both the transmission and reception. In this case, a transmission/reception branching filter is provided for transmitting a transmitting wave from a transmitting circuit to the antenna, transmitting a received wave to a receiving circuit from the antenna and preventing transmission of the transmitting wave to the receiving circuit. However, since the transmission/reception branching filter has large sizes, a circulator is employed instead of it for reducing the size of the wireless terminal device.

In the case where the circulator is employed, however, it is impossible to prevent completely the leakage of the transmitting wave from the transmitting circuit side to the receiving circuit side. Further, the receiving circuit is formed of a circuit of a heterodyne type which converts an intermediate frequency signal in an intermediate frequency circuit to a base band signal. Therefore, a large number of spurious response frequencies are present. It is also necessary to remove spurious jamming waves of such a large number of frequencies. Therefore, it is essential to arrange a band-pass filter passing only the received wave between the circulator and the receiving circuit.

<u>Disclosure of the Invention</u>

According to an aspect of the invention, a wireless terminal device of a type simultaneously performing transmission and reception includes a transmitting circuit, an antenna, a direct conversion receiving circuit, a circulator and a filter. The transmitting circuit generates a transmitting wave. The antenna externally emits the transmitting wave, and receives a reception wave. The direct conversion receiving circuit performs direct frequency conversion from the received wave to a base band signal. The circulator transmits the transmitting wave sent from the transmitting circuit to the antenna, and transmits the received wave sent from the antenna to the direct conversion receiving circuit. The filter is arranged between the circulator arid the direct conversion receiving circuit for intercepting the transmitting wave and passing the received wave.

According to the wireless terminal device described above, since the direct conversion receiving circuit for performing the direct frequency-conversion from the received wave to the base band signal, it is not necessary to provide an intermediate frequency circuit. Accordingly, the receiving circuit can have smaller sizes than a receiving circuit of a heterodyne type, and therefore the whole size of the wireless terminal device can be reduced.

According to the direct conversion receiving circuit, spurious response frequencies are fewer than those of the receiving circuit of the heterodyne type, and thus the spurious jamming waves to be removed are fewer. As a result, a size of a filter can be reduced, and the whole size of the wireless terminal device can be reduced.

According to still another aspect of the invention, a wireless terminal device of a type simultaneously performing transmission and reception includes a transmitting circuit, an antenna, a direct conversion receiving circuit, a circulator and a filter. The transmitting circuit produces a transmitting wave. The antenna externally emits the transmitting wave, and receives a reception wave. The direct conversion receiving circuit directly converts the received wave to a base band signal. The circulator transmits the transmitting wave sent from the transmitting circuit to the antenna, and transmits the received wave sent from the antenna to the direct conversion receiving circuit. The filter is arranged between the circulator and the direct conversion receiving circuit for intercepting the transmitting wave and passing the received wave. The direct conversion receiving circuit includes a phase shifter, a local oscillator, a first even harmonic mixer and a second even harmonic mixer. The phase shifter produces first and second received waves of phases shifted by 90° from each other in response to the received wave sent from the antenna. The local oscillator produces a local oscillation wave. The first even harmonic mixer mixes the first received wave and the local oscillation wave to produce a first base band signal. The second even harmonic mixer mixes the second received wave and the local oscillation wave to produce a second base band signal.

Since the wireless terminal device described above is provided with the direct conversion receiving circuit for performing the direct frequency-conversion from the received wave to the base band signal, it is not necessary to employ an intermediate frequency circuit. Accordingly, the receiving circuit can have smaller sizes than a receiving circuit of a heterodyne type, and therefore the whole size of the wireless terminal device can be reduced.

According to the direct conversion receiving circuit, the spurious response frequencies are fewer than those of the receiving circuit of the heterodyne type, and thus the spurious jamming frequencies to be removed are fewer. In and near a pass band, there is no wave, which must be attenuated to a large extent by a filter, as in the case of an image signal. As a result, a size of a filter can be reduced, and therefore the whole size of the wireless terminal device can be reduced.

In a conventional direct conversion receiving circuit, since the local oscillation wave and the received wave have equal frequencies, the local oscillation wave may leak toward the antenna, and thereby sensitivity may be deteriorated. According to the direct conversion receiving circuit in the foregoing wireless terminal device, however, the first and second even harmonic mixers are provided so that the local oscillation wave may have half a frequency of the received wave. Therefore, the local oscillation signal does not leak toward the antenna, and thus sensitivity does not deteriorate.

Brief Description of the Drawings

Fig. 1 is a black diagram showing a structure of a cellular telephone of an embodiment of the invention;
Fig. 2 is a block diagram showing a structure of a direct conversion receiving circuit shown in Fig. 1;
Fig. 3 shows by way of example a spurious response in a receiving circuit of a heterodyne type;
Fig. 4 shows frequency of spurious jamming waves shown in Fig. 3; and
Fig. 5 shows by way of example a spurious response in the direct conversion receiving circuit shown in Fig. 1.

Best Modes for Carrying Out the Invention

A cellular telephone according to an embodiment of the invention will now be described below with reference to the drawings. In the figures, the same or corresponding portions bear the same reference numbers, and the description thereof is not repeated.

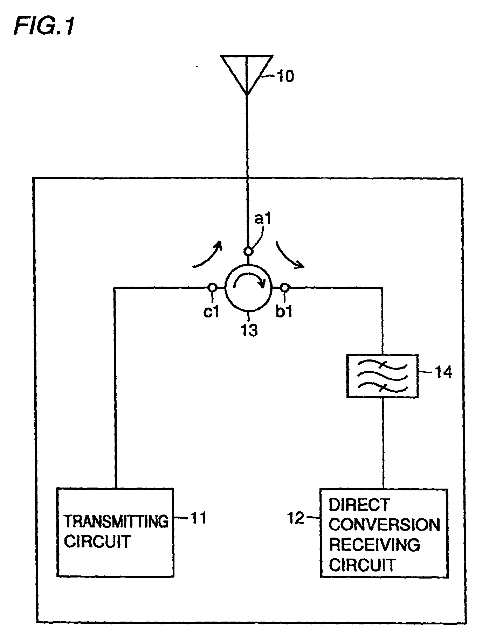

Referring to Fig. 1, a cellular telephone which is a kind of wireless terminal device includes an antenna 10, a transmitting circuit 11, a direct conversion receiving circuit 12, a circulator 13 and a band rejection filter 14.

The cellular telephone employs a CDMA system, and therefore simultaneously performs transmission and reception via single antenna 10. Therefore, frequencies of a transmitting wave and a received wave are set to different values, respectively. In this embodiment, the transmitting wave has a lower frequency than the received wave.

Transmitting circuit 11 issues the transmitting wave of a frequency ftx. Antenna 10 externally emits the transmitting wave, and receives a reception wave of a frequency of frx. Circulator 13 includes terminals a1, b1 and c1. Terminals a1, b1 and c1 are connected to antenna 10, band rejection filter 14 and transmitting circuit 11. Circulator 13 allows passage of waves from terminal a1 to terminal b1, from terminal b1 to terminal c1, and from terminal c1 to terminal a1, but intercepts passage of the waves in the opposite directions. Accordingly, the wave transmitted from transmitting circuit 10 reaches antenna 10, and the wave received by antenna 10 is sent to direct conversion receiving circuit 12. Band rejection filter 14 selectively intercepts the transmitting waved. In this embodiment, the transmitting and received waves have different frequencies. Band rejection filter 14 passes the received wave therethrough. Direct conversion receiving circuit 12 converts the received wave directly to a base band signal.

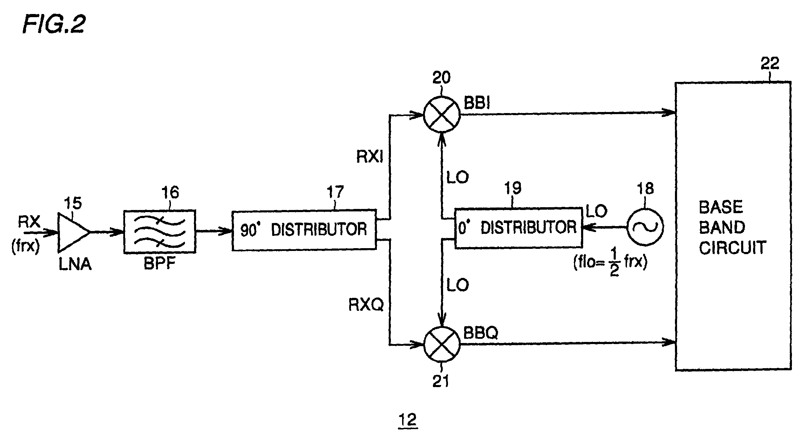

Fig. 2 shows a structure of direct conversion receiving circuit 12 shown in Fig. 1. Referring to Fig. 2, direct conversion receiving circuit 12 includes a low-noise amplifier (LNA) 15, a band-pass filter (BPF) 16, a 90° distributor 17, a local oscillator circuit 18, a 0° distributor 19, and even harmonic mixers 20 and 21.

Low-noise amplifier 15 amplifies the received wave passed through band rejection filter 14 with a high SN ratio. Band-pass filter 16 removes unnecessary signals, and passes only the necessary received signal therethrough. Ninety-degree distributor 17 produces I- and Q-channel received waves RXI and RXQ, which have phases shifted by 90° from each other, based on the received wave passed through band-pass filter 16. Local oscillator 18 generates a local oscillation wave. Local oscillation wave LO has a frequency flo which is half a frequency frx of the received wave. Zero-degree distributor 19 distributes local oscillation wave LO sent from local oscillator 18 to even harmonic mixers 20 and 21. Local oscillation waves LO applied to even harmonic mixers 20 and 21 have the same phases. Even harmonic mixer 20 mixes I-channel received wave RXI sent from 90° distributor 17 with local oscillation wave LO sent from 0° distributor 19, and thereby converts the radio-frequency to the base band frequency for producing an I-channel base band signal BBI. Even harmonic mixer 21 mixes Q-channel received wave RXQ sent from 90° distributor 17 with local oscillation wave LO sent from 0° distributor 19, and thereby converts the radio-frequency to the base band frequency for producing a Q-channel base band signal BBQ. Base band circuit 22 produces a low-frequency signal from I- and Q-channel base band signals BBI and BBQ.

An operation of the even harmonic mixers will now be described briefly. Assuming that the received wave supplied thereto has a frequency of frx, and local oscillation wave LO supplied thereto has a frequency of flo, the base band signal to be output has a frequency of fbb expressed by the following formula:

$$fbb = m \cdot frf \pm m \cdot flo$$

where m and n are integers, respectively.

In the even harmonic mixer, a frequency conversion efficiency is low when (m + n) is an even number, and it is high when (m + n) is an odd number. More specifically, in the case of m = 1 and n = 2, the base band signal has frequency fbb expressed by the following formula:

$$fbb = frx - 2 \cdot flo$$

Since there is a relationship of flo = frx/2 as described above, a base band signal of a low frequency (fbb = 0) can be obtained with a high conversion efficiency. Accordingly, the received wave received by antenna 10 is directly converted to a low frequency without being temporarily converted to an intermediate frequency.

Even harmonic mixers 20 and 21 shown in Fig. 2 are the same as that shown in Fig. 40 of U. S. Patent Specification No. 5,787,126 (Japanese Patent Laying-Open No. 8-242261), and therefore are not described in further greater detail.

Operations of the cellular telephone having the foregoing structure will now be described.

The transmitting wave sent from transmitting circuit 11 is sent to antenna 10 via circulator 13 (c1 - a1), and is externally emitted. The externally supplied reception wave is received by antenna 10, and then is sent via circulator 13 (a1 - b1) and band rejection filter 14 to direct conversion receiving circuit 12. In this manner, the transmission and the reception are performed simultaneously.

According to the above embodiment, direct conversion receiving circuit 12 is used as the receiving circuit. The advantage of this is as follows:

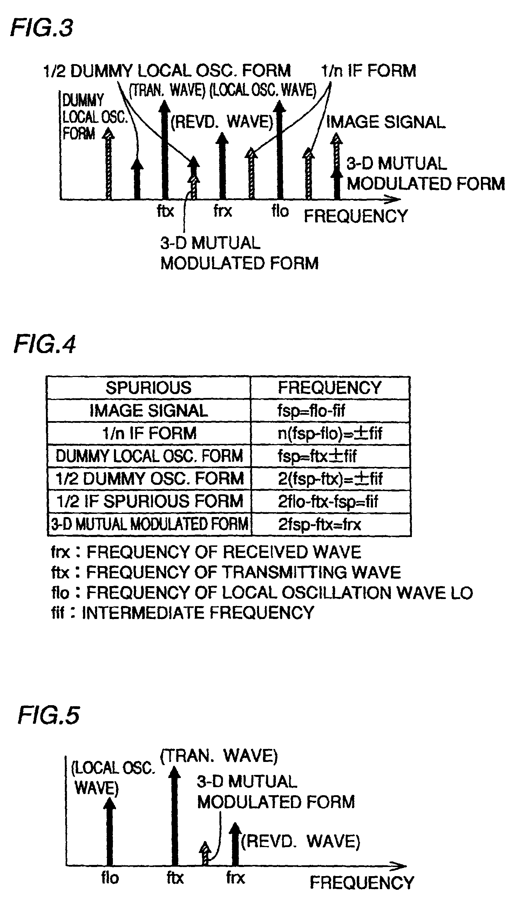

Since the receiving circuit of the heterodyne type uses the intermediate frequency signal having an intermediate frequency fif, various spurious jamming waves occur due to it as shown in Fig. 3. Assuming that the spurious jamming waves have a frequency fsp, the respective spurious jamming waves and frequencies thereof have the relationships shown in Fig. 4. As shown in Fig. 3, these spurious jamming waves occur on both the lower and higher frequency side with respect to frequency frx of the received wave. However, it is hardly possible to remove by the filter the spurious of the three-dimensional mutual modulation form. In general, the requirement relating to this spurious is satisfied by distortion characteristics in the stage of designing the mixer. When the receiving circuit of the heterodyne type is used, all of them must be removed. Therefore, the filter arranged between the circulator and the receiving circuit must be a band-pass filter which allows passage of only the frequency of the received waved. In particular, the frequency of the image signal is very dose to the reception pass band so that very steep filter characteristics are required. Accordingly, the filter must be large in size.

On the other hand, direct conversion receiving circuit 12 does not use the intermediate frequency signal, and therefore the spurious response shown in Fig. 5 is achieved. The frequencies thereof are the same as those relating to Fig. 3 and shown in Fig. 4. Accordingly, it is hardly necessary to attenuate the spurious jamming waves supplied from antenna 10. In the case where direct conversion receiving circuit 12 is employed, therefore, filter 14 is not required to be a band-pass filter film in contrast to the case of employing the receiving circuit of the heterodyne type, and filter 14 which removes only the transmitting wave can be adequately employed. The band rejection filter removes the frequencies which are fewer than those removed by the band-pass filter. Further, even in the case of attenuating the spurious jamming wave, steep filter characteristics are not required because the frequency of the jamming wave is spaced from frequency frx of the received wave owing to the frequency structure of the system of the cellular telephone. Therefore, the size can be small even in the structure using the band-pass filter. Accordingly, the filter size can be reduced so that the sizes of the whole cellular telephone can be reduced.

As described above, the band rejection filter can be adequately used because LNA 15 has frequency characteristics, and the spurious jamming wave spaced from the pass band can be passed through LNA 15 to achieve the similar effect achieved by passing it through the filter.

As described above, receiving circuit 12 as well as filter 14 arranged between circulator 13 and receiving circuit 14 can be reduced in size owing to provision of the direct conversion receiving circuit.

However, a general direct conversion receiving circuit may cause deteriorate the sensitivity due to leakage of the local oscillation wave toward the antenna because the frequency of the local oscillation wave is equal to that of the received wave. For overcoming this problem, the receiving circuit must have very large sizes, and therefore it is practically impossible to use it as the receiving circuit of the wireless terminal device such as a cellular telephone. This embodiment is provided with even harmonic mixers 20 and 21 so that local oscillation wave LO may have frequency flo equal to half the frequency frx of received wave. Thereby, leakage of local oscillation wave LO toward antenna 10, which may cause deterioration in sensitivity, does not occur Accordingly, the receiving circuit can be practically used as the receiving circuit of the wireless terminal device such as a cellular telephone.

In this embodiment, band rejection filter 14 is arranged between circulator 13 and direct conversion receiving circuit 12. Instead of this, a band-pass filter passing the received wave may be employed.

A band-pass filter passing the transmitting wave may be arranged between transmitting circuit 11 and circulator 13.

The foregoing and other objects, features, aspects and advantages of the present invention will become more apparent from the following detailed description of the present invention when taken in conjunction with the accompanying drawings.

## Claims

1. A wireless terminal device of a type simultaneously performing transmission and reception, comprising:

   a transmitting circuit (11) for generating a transmitting wave;
   an antenna (10) for externally emitting a transmitting wave, and receiving a reception wave; a direct conversion receiving circuit (12) for performing direct frequency conversion from the received wave to a base band signal;
   a circulator (13) for transmitting the transmitting wave sent from said transmitting circuit (11), and transmitting the received wave sent from said antenna (10) to said direct conversion receiving circuit (12); and a filter (14) arranged between said circulator (13) and said direct conversion receiving circuit (12) for intercepting said transmitting wave and passing said received wave.

2. A wireless terminal device of a type simultaneously performing transmission and reception, comprising:

   a transmitting circuit (11) for producing a transmitting wave;
   an antenna (10) for externally emitting said transmitting wave, and receiving a reception wave;
   a direct conversion receiving circuit (12) for directly converting the received wave to a base band signal;
   a circulator (13) for transmitting the transmitting wave sent from said transmitting circuit (11) to said antenna (10), and transmitting the received wave sent from said antenna (10) to said direct conversion receiving circuit (12); and
   a filter (14) arranged between said circulator (13) and said direct conversion receiving circuit (12) for intercepting said transmitting wave and passing said received wave, wherein
   said direct conversion receiving circuit (12) includes:
   a phase shifter (17) for producing first and second received waves (RXI and RXQ) of phases shifted by 90° from each other in response to the received wave sent from said antenna (10),
   a local oscillator (18) for producing a local oscillation wave (LO),
   a first even harmonic mixer (20) for mixing said first received wave (RXI) and said local oscillation wave (LO) to produce a first base band signal (BBI), and
   a second even harmonic mixer (21) for mixing said second received wave (RXQ) and said local oscillation wave (LO) to produce a second base band signal (BBQ).

3. The wireless terminal device according to claim 1 or 2, wherein

   said filter (14) is a band-pass filter (14).

4. The wireless terminal device according to claim 1 or 2, wherein

   said filter (14) is a band rejection filter (14).

5. The wireless terminal device according to claim 2, wherein

   said local oscillation wave (LO) has a frequency equal to half a frequency (frx) of said received wave.

**FIG.1**

FIG.2

15 LNA
16 BPF
17 90° DISTRIBUTOR
18 (flo = ½ frx)
19 0° DISTRIBUTOR
20 BBI
21 BBQ
22 BASE BAND CIRCUIT

RX (frx)

RXI

RXQ

LO

LO

LO

12

EP 1 089 446 A1

7

## FIG.3

1/2 DUMMY LOCAL OSC. FORM     1/n IF FORM

(TRAN. WAVE) (LOCAL OSC. WAVE)

DUMMY LOCAL OSC. FORM

(REVD. WAVE)

IMAGE SIGNAL

3-D MUTUAL MODULATED FORM

ftx    frx    flo   FREQUENCY

3-D MUTUAL MODULATED FORM

## FIG.4

| SPURIOUS | FREQUENCY |
|---|---|
| IMAGE SIGNAL | $fsp=flo-fif$ |
| 1/n IF FORM | $n(fsp-flo)=\pm fif$ |
| DUMMY LOCAL OSC. FORM | $fsp=ftx\pm fif$ |
| 1/2 DUMMY OSC. FORM | $2(fsp-ftx)=\pm fif$ |
| 1/2 IF SPURIOUS FORM | $2flo-ftx-fsp=fif$ |
| 3-D MUTUAL MODULATED FORM | $2fsp-ftx=frx$ |

frx : FREQUENCY OF RECEIVED WAVE
ftx : FREQUENCY OF TRANSMITTING WAVE
flo : FREQUENCY OF LOCAL OSCILLATION WAVE LO
fif : INTERMEDIATE FREQUENCY

## FIG.5

(LOCAL OSC. WAVE)

(TRAN. WAVE)

3-D MUTUAL MODULATED FORM

(REVD. WAVE)

flo    ftx    frx    FREQUENCY

# INTERNATIONAL SEARCH REPORT

| International application No. |
|---|
| PCT/JP99/01204 |

## A. CLASSIFICATION OF SUBJECT MATTER
Int.Cl⁶ H04B1/30, H04L27/22, H04J13/00

According to International Patent Classification (IPC) or to both national classification and IPC

## B. FIELDS SEARCHED

Minimum documentation searched (classification system followed by classification symbols)
Int.Cl⁶ H04B1/30, H04L27/22, H04J13/00

Documentation searched other than minimum documentation to the extent that such documents are included in the fields searched

| | | | |
|---|---|---|---|
| Jitsuyo Shinan Koho | 1926-1999 | Toroku Jitsuyo Shinan Koho | 1994-1999 |
| Kokai Jitsuyo Shinan Koho | 1971-1999 | Jitsuyo Shinan Toroku Koho | 1996-1999 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | JP, 7-95110, A (Toshiba Corp.), | 1-4 |
| Y | 7 April, 1995 (07. 04. 95) (Family: none) | 5 |
| Y | JP, 8-242261, A (Mitsubishi Electric Corp.), 17 September, 1996 (17. 09. 96) & US, 5787126, A | 5 |

☐ Further documents are listed in the continuation of Box C.  ☐ See patent family annex.

| | |
|---|---|
| * Special categories of cited documents: <br> "A" document defining the general state of the art which is not considered to be of particular relevance <br> "E" earlier document but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| 3 June, 1999 (03. 06. 99) | 15 June, 1999 (15. 06. 99) |

| Name and mailing address of the ISA/ <br> Japanese Patent Office | Authorized officer |
|---|---|
| Facsimile No. | Telephone No. |

Form PCT/ISA/210 (second sheet) (July 1992)